# EUROPÄISCHE PATENTSCHRIFT

(11) **EP 1 798 523 B1**
(45) Veröffentlichungstag und Bekanntmachung des Hinweises auf die Patenterteilung: **07.05.2008**
(21) Anmeldenummer: 06123243.5
(22) Anmeldetag: 31.10.2006
(51) Int. Cl.: G01D 5/14, H05K 13/04

(54) **Messvorrichtung zum gleichzeitigen Erfassen eines Drehwinkels und einer Verschiebeposition**
Measuring device for simultaneously determining a rotation angle and a displacement position
Dispositif de mesure destiné à la saisie simultanée d'un angle de rotation et d'une position de décalage

(30) Priorität: 13.12.2005 DE 102005059551
(43) Veröffentlichungstag der Anmeldung: 20.06.2007
(73) Patentinhaber: SIEMENS AKTIENGESELLSCHAFT, 80333 München (DE)
(72) Erfinder: Burger, Stefan, 81379 München (DE)

(56) Entgegenhaltungen:
- WO-A-03/032704

## Beschreibung

Die Erfindung betrifft eine Messvorrichtung zum gleichzeitigen Erfassen eines Drehwinkels und einer Verschiebeposition. Die Erfindung betrifft insbesondere eine Messvorrichtung zum Erfassen des Drehwinkels und der Verschiebeposition einer Haltevorrichtung für elektronische Bauelemente, welche in der Bestücktechnik typischerweise in Form von so genannten Saugpipetten zum Transport von elektronischen Bauelementen verwendet werden.

Die automatische Bestückung von Substraten bzw. Leiterplatten mit elektronischen Bauelementen erfolgt heutzutage üblicherweise mittels so genannten Bestückautomaten. Dabei werden Bauelemente von einer Bauelementzuführeinrichtung mittels eines Bestückkopfes zu einer Aufsetzposition auf einer Leiterplatte transportiert. Die Aufnahme der Bauelemente durch den Bestückkopf erfolgt mittels so genannten Saugpipetten, welche mit einer Vakuumerzeugungseinheit pneumatisch gekoppelt sind, so dass die zu bestückenden Bauelemente während des Transports durch den Bestückkopf zuverlässig durch einen Ansaug-Unterdruck gehalten werden können.

Um ein definiertes Aufsetzen der Bauelemente auf der Leiterplatte zu ermöglichen, erfolgt für jedes aufgenommene Bauelement eine optische Vermessung, bei der insbesondere die Lage einschließlich der Winkelposition des aufgenommenen Bauelement relativ zu dem Bestückkopf vermessen wird. Um ein aufgenommenes Bauelement mit der richtigen Winkelposition auf die Leiterplatte aufsetzen zu können, ist neben einer definierten axialen Bewegung der Saugpipette relativ zu dem Bestückkopf auch eine Drehbewegung der Saugpipette erforderlich. Um einen präzisen Aufsetzvorgang zu gewährleisten, welcher insbesondere aufgrund der in den letzten Jahren stets zunehmenden Miniaturisierung von elektronischen Bauelementen für einen korrekten Bestückvorgang unverzichtbar ist, werden deshalb Sensorsysteme verwendet, welche sowohl die axiale Position der Saugpipette als auch den Drehwinkel der Saugpipette genau erfassen können.

Für diesen Zweck ist ein Sensorsystem aus WO 03/032704 bekannt, welches zwei separate Sensoren aufweist, wobei ein Sensor ein Drehwinkelsensor zur Erfassung des aktuellen Drehwinkels einer Saugpipette und der andere Sensor ein Linearsensor zur Erfassung der axialen Position der Saugpipette ist. Die Verwendung von zwei separaten, voneinander unabhängigen Sensoren hat den Nachteil, dass zumindest einer der beiden Sensoren mit einem bewegten System gekoppelt werden muss. Dies bedeutet, dass entweder der Drehwinkelsensor mit der axial verschobenen Saugpipette oder der Sensor für die Linearbewegung mit der drehenden Saugpipette gekoppelt werden muss.

Ferner ist ein optisches Messsystem zur gleichzeitigen Erfassung eines Drehwinkels und einer Verschiebeposition bekannt, welches aus einem optischen Sensor und einem Zylinder mit einem aufgebrachten Strichgitter besteht. Der optische Sensor kann durch eine Erfassung von Strichgitter-Positionen sowohl den Drehwinkel als auch die axiale Verschiebeposition einer mit dem Zylinder mechanisch gekoppelten Saugpipette erfassen. Dieses Messsystem hat den Nachteil, dass für eine hohe Messgenauigkeit auf einem zylindrischen Gegenstand ein räumlich exakt definiertes Strichgitter vorhanden sein muss. Die Herstellung eines derartigen Strichgitter-Zylinders ist jedoch sehr teuer. Ferner ist zur Vermessung der Strichgitter-Positionen ein aufwendiger und damit ebenfalls teurer optischer Sensor erforderlich.

Der Erfindung liegt die Aufgabe zugrunde, eine Messvorrichtung zum gleichzeitigen Erfassen eines Drehwinkels und einer axialen Verschiebeposition eines Objekts zu schaffen, welche Messvorrichtung zum einen zuverlässig arbeitet und zum anderen in der Herstellung kostengünstig ist.

Diese Aufgabe wird gelöst durch eine Messvorrichtung zum gleichzeitigen Erfassen eines Drehwinkels und einer Verschiebeposition eines Objekts mit den Merkmalen des unabhängigen Anspruchs 1.

Die erfindungsgemäße Messvorrichtung umfasst einen Drehgeber, welcher mit dem Objekt ortsfest verbindbar ist und welcher mehrere detektierbare Elemente umfasst, die entlang einer Außenumfangslinie des Drehgebers in äquidistanten Abständen angeordnet sind. Die erfindungsgemäße Messvorrichtung umfasst ferner eine Führungseinrichtung, die derart ausgebildet ist, dass der Drehgeber um eine Drehachse drehbar und entlang dieser Drehachse verschiebbar gelagert ist. Ferner umfasst die erfindungsgemäße Messvorrichtung ein Sensor-Array, welches mehrere Einzeldetektoren umfasst, die in einer Ebene parallel zur Drehachse angeordnet sind, wobei die Ebene einen vorbestimmten Abstand zum Außenrand des Drehgebers aufweist. Außerdem ist eine Auswerteeinheit vorgesehen, welche mit den Einzeldetektoren gekoppelt ist und welche derart eingerichtet ist, dass aus dem Signal der Einzeldetektoren sowohl der Drehwinkel als auch die Verschiebeposition des Objekts ermittelbar ist. Bei der erfindungsgemäßen Messvorrichtung ist die Ermittlung von Verschiebeposition und Drehwinkel dahingehend entkoppelt, dass bei einem Verschieben des Drehgebers Messsignale von unterschiedlichen Einzeldetektoren erfasst und ausgewertet werden, welche Einzeldetektoren neben unterschiedlichen Längsabschnitten der Drehachse angeordnet sind, und dass bei einem Verdrehen des Drehgebers zumindest ein Messsignal eines Einzeldetektors erfasst und ausgewertet wird, der neben einem bestimmten Längsabschnitt der Drehachse angeordnet ist.

Der Erfindung liegt die Erkenntnis zugrunde, dass eine gleichzeitig Erfassung von Drehwinkel und Verschiebeposition auf einfache Weise durch die Verwendung eines zweidimensionalen Sensor-Arrays möglich ist, wobei das Sensor-Array zumindest eine Spalte von Einzeldetektoren aufweist, welche Spalte parallel zu der durch die Führungseinrichtung vorgegebenen Verschieberichtung des Objekts orientiert ist.

Das Objekt ist beispielsweise ein hohler Schaft, welcher sowohl als Welle für eine Saugpipette als auch als Welle für den Drehgeber dient. Die Führungseinrichtung ist bevorzugt dieser Welle zugeordnet, welche mit dem Objekt in mechanisch starrer Weise verbunden ist. In diesem Fall ist der Drehgeber nicht unmittelbar, sondern lediglich mittelbar durch eine Führung der Welle sowohl drehbar als auch verschiebbar gelagert.

Die Ebene, in welcher die Einzeldetektoren des Sensor-Arrays angeordnet sind, kann eine plane Ebene oder auch eine Fläche sein, die eine Krümmung um die Drehachse herum aufweist. Eine derartig gekrümmte Ebene hat den Vorteil, dass sämtliche Einzeldetektoren des Sensor-Arrays auch dann in demselben vorbestimmten Abstand zum Außenrand des Drehgebers angeordnet sein können, wenn das Sensor-Array Einzeldetektoren aufweist, die in Form eines zweidimensionalen Gitters in der gekrümmten Ebene angeordnet sind.

Es wird ausdrücklich darauf hingewiesen, dass der Drehgeber nicht, wie aus dem Stand der Technik bekannt, ein Zylinder sein muss, welcher zur Erfassung der Verschiebeposition eine Längserstreckung parallel zur Drehachse aufweist. Vielmehr kann der Drehgeber ein scheibenartiges Geberrad mit einer im Prinzip beliebig kleinen Breite. Dies hat den Vorteil, dass der bewegliche Drehgeber mit einer geringen Masse hergestellt werden kann, so dass die Messvorrichtung insgesamt eine geringe mechanische Trägheit aufweist. Ein weiterer Vorteil eines scheibenartigen Geberrades im Vergleich zu zylindrischen Drehgebern besteht darin, dass ein scheibenartiges Geberrad einen deutlich geringeren Bauraum erfordert und somit einen größeren axialen Verschiebebereich des Objekts und damit einen größeren Messbereich der Messvorrichtung bei der Messung von Verschiebepositionen ermöglicht.

Gemäß Anspruch 2 sind die Einzeldetektoren in Sensor-Zeilen und in Sensor-Spalten angeordnet, wobei die Sensor-Zeilen senkrecht zur Drehachse und die Sensor-Spalten parallel zur Drehachse orientiert sind. Die orthogonale Anordnung der Einzeldetektoren auf einem zweidimensionalen Raster hat den Vorteil, dass die Auswertung der Sensorsignale auf einfache Weise erfolgen kann, da die zu jedem detektierbaren Element nächstliegend benachbarten Sensoren entweder parallel oder orthogonal zu den Bewegungsfreiheitsgraden des Geberrades angeordnet sind. Bevorzugt weisen die Sensor-Zeilen zur Bestimmung der Winkelposition jeweils gerade zwei Sensoren auf, so dass das Sensor-Array senkrecht zu der Drehachse innerhalb einer kompakten Bauform realisiert werden kann. Die Anordnung der Einzeldetektoren in genau zwei Sensor-Spalten hat im Vergleich zu einem Sensor-Array mit lediglich einer Sensor-Reihe den Vorteil, dass die genaue Winkelposition des Drehgebers stets eindeutig bestimmt werden kann. Da Sensoren üblicherweise nur Intensitäten messen, kann bei der Verwendung von lediglich einer Sensor-Reihe nämlich im allgemeinen nicht unterschieden werden, ob sich ein detektierbares Element aus Sicht des Sensors leicht links oder leicht rechts von der Sensormitte befindet.

Es wird darauf hingewiesen, dass die Genauigkeit, mit der die Einzeldetektoren innerhalb der Sensor-Spalten räumlich angeordnet sind, maßgeblich ist für die Genauigkeit der Messvorrichtung hinsichtlich der Bestimmung der axialen Position. In analoger Weise ist ein genauer Abstand der Einzeldetektoren innerhalb einer Sensor-Zeile, d.h. senkrecht zu der Drehachse, für die Präzision der Drehwinkelbestimmung maßgeblich.

Gemäß Anspruch 3 ist die Auswerteeinheit derart eingerichtet, dass der genaue Drehwinkel aus dem Signal von zwei Einzeldetektoren ermittelbar ist, welche unterschiedlichen Sensor-Spalten zugeordnet sind. Eine derartige Interpolation zwischen den Signalen bzw. den Signalstärken von zwei benachbarten Sensor-Spalten ergibt auf vorteilhafte Weise bei einem geringen aparativen Aufwand eine hohe Messgenauigkeit bei der Ermittlung des Drehwinkels.

Gemäß Anspruch 4 sind die detektierbaren Elemente entlang des Außenumfangs des Drehgebers in jeweils einem Element-Abstand voneinander angeordnet und zwei in einer Sensor-Zeile benachbarte Einzeldetektoren sind in einem Sensor-Abstand voneinander angeordnet. Dabei ist der Sensor-Abstand gerade halb so groß wie der Element-Abstand. Dies hat den Vorteil, dass bei einer Drehung des Drehgebers ein ausgewählter Einzeldetektor des Sensor-Arrays ein Cosinus-Signal aufnimmt. Der zu dem ausgewählten Einzeldetektor unmittelbar benachbarte Einzelsensor misst bei derselben Drehung des Gebers ein Sinus-Signal. Durch eine Interpolation zwischen beiden Signalen lässt sich die Winkelposition besonders genau bestimmen.

Gemäß Anspruch 5 weist die Auswerteeinheit einen Zähler auf, mit dem Signalfolgen von zwei zu unterschiedlichen Sensor-Spalten zugeordneten Einzeldetektoren zählbar sind. Somit kann durch eine einmalige Initialisierung der Messvorrichtung der Drehwinkel auch bei einer vollständigen Drehung oder bei mehrfachen Drehungen präzise ermittelt werden.

Es wird darauf hingewiesen, dass der Zähler auch in einer eigenen Zähleinheit, welche von der Auswerteeinheit physikalisch getrennt ist, realisiert werden kann. Ferner wird darauf hingewiesen, dass der Zähler nicht nur mittels einer entsprechenden Hardware, sondern auch programmtechnisch in Form von Software realisiert werden kann.

Gemäß Anspruch 6 ist die Auswerteeinheit derart eingerichtet ist, dass die genaue Verschiebeposition aus dem Signal von zumindest zwei Einzeldetektoren ermittelbar ist, welche unterschiedlichen Sensor-Zeilen zugeordnet sind. Diese bedeutet, dass zwischen den Signalen der beiden beteiligten Einzeldetektoren eine Interpolation durchgeführt wird, so dass die Verschiebeposition mit einer besonders hohen Genauigkeit bestimmt werden kann.

Gemäß Anspruch 7 ist der Drehgeber ein Multipol-Magnetrad und die detektierbaren Elemente sind Magnete, die derart angeordnet sind, dass sich entlang des Außenrandes des Multipol-Magnetrades abwechselnd ein Nord- und ein Südpol befindet. Ferner sind die Einzeldetektoren Magnetfeld-Sensoren. In diesem Fall erfolgt die Positionsermittlung sowohl des Drehwinkels als auch der axialen Position durch eine Auswertung der von verschiedenen Magnetfeld-Einzelsensoren erfassten Magnetfeldstärken. Das magnetische Polrad bzw. das Multipol-Magnetrad kann preiswert mit hoher Genauigkeit hergestellt werden, so dass die Messvorrichtung zum einen eine hohe Messgenauigkeit aufweist und zum anderen vergleichsweise preisgünstig realisiert werden kann.

Das Sensor-Array mit der Mehrzahl von Magnetfeld-Sensoren kann beispielsweise im Rahmen eines Halbleiter-Fertigungsprozesses ebenfalls mit einer hochgenauen relativen Anordnung der einzelnen Magnetfeld-Sensoren zueinander und zudem auch noch kostengünstig hergestellt werden. Eine genau hergestelltes Sensor-Array liegt dann vor, wenn die EinzelDetektoren an exakt vorbestimmten Positionen auf einem zweidimensionalen Raster angeordnet sind. Da sowohl das magnetische Polrad als auch das Sensor-Array für die Genauigkeit der Messvorrichtung von großer Bedeutung sind, ermöglicht ein hochgenau hergestelltes Sensor-Array in Verbindung mit einem präzise gefertigten magnetischen Polrad insgesamt eine hohe Messgenauigkeit der beschriebenen Messvorrichtung.

Ein weiterer Vorteil der Verwendung von Magneten als detektierbare Elemente besteht darin, dass die gesamte Messvorrichtung völlig verschleißfrei ist, da sowohl die Messung des Drehwinkels als auch die Messung der axialen Verschiebeposition berührungslos erfolgen kann. Bevorzugt werden als detektierbare Elemente Permanentmagnete verwendet, so dass die gesamte Messvorrichtung ein mechanisch sehr robustes System darstellt, bei dem keinerlei bewegliche elektrische Leitungen erforderlich sind.

Gemäß Anspruch 8 umfasst das Multipol-Magnetrad eine Nabe und einen um die Nabe herum angeordneten Ring, welcher einen Hartferrit-Werkstoff aufweist. Dies ermöglicht auf einfache Weise eine Magnet-Anordnung, bei der die Magnete entlang des Außenrandes des Multipol-Magnetrades einen geringen Abstand voneinander aufweisen oder bei die Magnete vorzugsweise unmittelbar nebeneinander angeordnet sind.

Gemäß Anspruch 9 ist der Ring aus Hartferrit auf die Nabe aufgeklebt. Die Klebeverbindung stellt auf vorteilhafte Weise eine einfache und mechanisch stabile Verbindung zwischen zwei unterschiedlichen Materialien dar, von denen zumindest das Hartferrit-Material schwer bearbeitbar ist.

Gemäß Anspruch 10 sind die Magnetfeld-Sensoren Hall-Sensoren und/oder Magnetowiderstand-Sensoren. Beide Arten von Sensoren stellen hochempfindliche Detektoren zur Erfassung von Magnetfeldstärken dar. Unter dem Begriff Magnetowiderstand-Sensoren werden in diesem Zusammenhang alle Arten von Sensoren verstanden, bei denen ein elektrischer Widerstand gemessen wird, der von der jeweils vorhandenen Magnetfeldstärke abhängt. Dazu zählen insbesondere Sensoren, die auf dem Magneto-Resistive (MR)-Effekt, auf dem Anisotrope-Magneto-Resistive (AMR)-Effekt, auf dem Giant-Magneto-Resistive (GMR)-Effekt oder auf dem Tunnel-Magneto-Resistive (TMR)-Effekt beruhen.

Gemäß Anspruch 11 weist die Messvorrichtung zusätzlich ein weiteres Sensor-Array auf, welches mehrere einzelne Detektoren umfasst, die in einer weiteren Ebene parallel zur Drehachse angeordnet sind, welche weitere Ebene einen vorbestimmten Abstand zum Außenrand des Drehgebers aufweist, wobei die weiteren Einzeldetektoren ebenfalls mit der Auswerteeinheit gekoppelt sind. Die Verwendung eines weiteren Sensor-Arrays hat den Vorteil, dass durch eine redundante bzw. zusätzliche Erfassung von Drehwinkel und Verschiebeposition bei einer gemeinsamen Auswertung der Messsignale von beiden Sensor-Arrays eine noch höhere Messgenauigkeit erzielt werden kann. Dabei erfolgt die Auswertung der Messsignale der weiteren Einzeldetektoren in gleicher Weise wie die oben erläuterte Auswertung der Signale der Einzeldetektoren des ersten Sensor-Arrays.

Gemäß Anspruch 12 sind das Sensor-Array und das weitere Sensor-Array auf einander gegenüberliegenden Seiten des Drehgebers angeordnet. Dies hat den Vorteil, dass die Messung des jeweiligen Drehwinkels unabhängig werden kann (a) von einer Exzentrizität der Welle, (b) von einer Exzentrizität des Multipolmagnetrades, (c) von einer ungleichmäßigen Magnetfeldstärke der einzelnen Magnete und/oder von (d) einem Spiel der Welle in der Führungseinrichtung. Auf diese Weise wird die Genauigkeit der Messvorrichtung weiter erhöht. Ferner kann der Aufwand für die Lagerung der Welle und für die gesamte Montage der Messvorrichtung reduziert werden, ohne dass die Genauigkeit der Messvorrichtung wesentlich verschlechtert wird.
Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine Messvorrichtung mit einem Multipol-Magnetrad und einen Sensor-Array und
- Figur 2: eine Messvorrichtung mit einem Multipol-Magnetrad und zwei einander gegenüberliegend angeordneten Sensor-Arrays.

An dieser Stelle bleibt anzumerken, dass sich in der Zeichnung die Bezugszeichen von gleichen oder von einander entsprechenden Komponenten lediglich in ihrer ersten Ziffer unterscheiden.

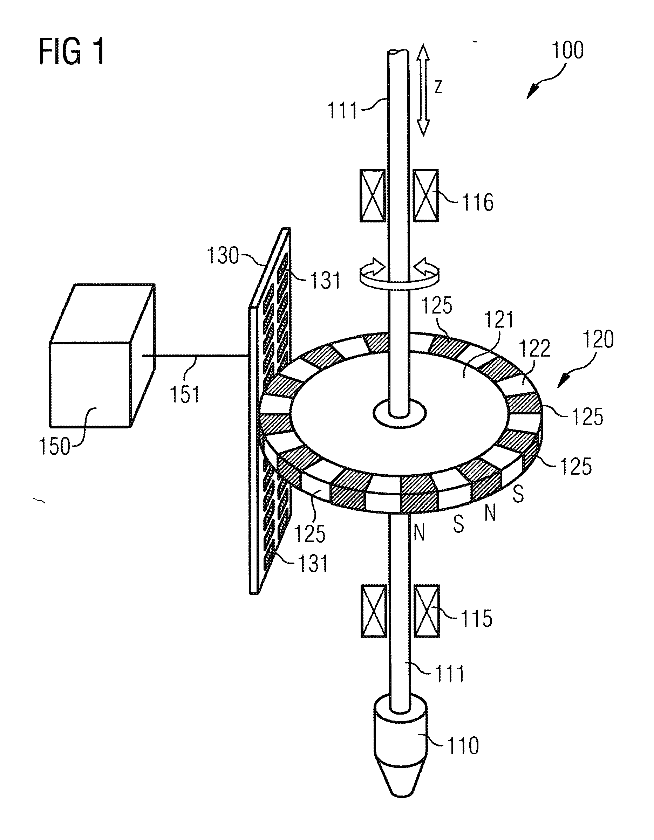

Figur 1 zeigt eine Messvorrichtung 100 zur gleichzeitigen Erfassung eines Drehwinkels und einer Verschiebeposition einer Saugpipette 110, welche als Haltevorrichtung für Bauelemente zur Durchführung eines Bestückvorgangs verwendet wird. Die Saugpipette 110 befindet sich an einem hohlen Schaft 111, welcher eine Welle darstellt, die mittels zweier Lagerelemente 115 und 116 gelagert ist. Die Lagerung ist derart ausgebildet, dass sich der hohle Schaft 111 um seine Längsachse drehen und außerdem entlang seiner Längsachse parallel zu einer z-Richtung axial verschieben kann. Die Welle ist in nicht dargestellter Weise sowohl mit einem Linearantrieb zur axialen Verschiebung des hohlen Schafts 111 und mit einem Drehantrieb zur Drehung des hohlen Schafts 111 um seine Längsachse gekoppelt. Der hohle Schaft 111 dient der Übertragung eines Unterdrucks von einer nicht dargestellten Vakuumerzeugungseinrichtung auf die Saugpipette 110, so dass ein Bauelement bei einem entsprechenden Anlegen eines Unterdrucks von der Saugpipette 110 pneumatisch gehalten werden kann.

Die Messvorrichtung 100 umfasst ferner einen Drehgeber, welcher als ein Multipol-Magnetrad 120 ausgebildet ist. Das Multipol-Magnetrad 120 ist an dem hohlen Schaft 111 fixiert, so dass sich bei einer Drehung des hohlen Schafts 111 das Multipol-Magnetrad 120 relativ zu einem Sensor-Array 130 verdreht und bei einer axialen Verschiebung des hohlen Schafts 111 bzw. der Saugpipette 110 das Multipol-Magnetrad 120 ebenso relativ zu dem Sensor-Array 130 entlang der z-Richtung axial verschoben wird.

Das Multipol-Magnetrad 120 umfasst eine Nabe 121, an der zu dem hohlen Schaft 111 in konzentrischer Weise ein Ring 122 befestigt ist, welcher ein Hartferrit-Material aufweist. In dem Ring sind entlang einer Außenumfangsfläche eine Mehrzahl von Permanentmagneten 125 angeordnet bzw. ausgebildet. Die Anordnung der Magneten 125 ist derart gewählt, dass sich entlang des Außenrandes des Multipol-Magnetrades 120 abwechselnd ein Nord- und ein Südpol befindet. Somit führt eine Drehung der Saugpipette 110 bzw. des hohlen Schafts 111 an den Ort des Sensor-Arrays 130 zu einem zeitlich wechselnden Magnetfeld, welches von Einzeldetektoren 131 des Sensor-Arrays 130 erfasst wird. Bei einer axialen Verschiebung der Saugpipette 110 bzw. des hohlen Schafts 111 entlang der z-Achse wird von dem Sensor-Array 130 ein Magnetfeld gemessen, wobei sich der Ort der jeweils größten Magnetfeldstärke auf der Oberfläche des Sensor-Arrays 130 entlang der z-Richtung verschiebt.

Wie aus Figur 1 ersichtlich, sind die Vielzahl von Einzeldetektoren 131, welche jeweils einen Magnetfeld-Sensor darstellen, entlang zweier Spalten angeordnet. Die Einzeldetektoren 131 sind somit auf einem zweidimensionalen Raster angeordnet, welches aus zwei Sensor-Spalten besteht, die parallel zu der Drehachse bzw. zu der Welle 111 orientiert sind.

Das Sensor-Array 130 ist über eine Datenleitung 151 mit einer Auswerteeinheit 150 gekoppelt. Die Auswerteeinheit 150 ist derart eingerichtet, dass zur Bestimmung des Drehwinkels bzw. der Verschiebeposition jeweils die Signale der Einzeldetektoren 131 herangezogen werden, die im Vergleich zu den anderen Einzeldetektoren 131 einem starken Magnetfeld durch das Multipol-Magnetrad 120 ausgesetzt sind und welche somit die am besten zu verwertenden Messsignale bereitstellen.

Um den aktuellen Drehwinkel der Saugpipette 110 bzw. des hohlen Schafts 111 möglichst genau zu bestimmen, erfolgt in der Auswerteeinheit 150 eine Auswertung, bei der zwischen den Signalen bzw. zwischen den Signalstärken von zwei bzw. von vier Einzeldetektoren 131 interpoliert wird, welche Einzeldetektoren zwei benachbarten Sensor-Spalten und zwei benachbarten Sensor-Zeilen zugeordnet sind. Um den Drehwinkel in einem weiten Winkelbereich messen zu können, ist die Auswerteeinheit 150 mit einem Inkrementalzähler ausgestattet, so dass bei einer größeren Drehung des Multipol-Magnetrades 120 die Perioden einer erzeugten periodischen Schwankung der Magnetfeldstärke gezählt werden können. Somit kann nach einer anfänglichen Initialisierung des Drehwinkels jeder beliebige Drehwinkel innerhalb eines Winkelbereichs von 0° bis 360° mit hoher Genauigkeit detektiert werden.

Die Auswahl der Einzeldetektoren 131, deren Messsignale für die Ermittlung des Drehwinkels und der Axialposition herangezogen werden, erfolgt mittels einer Steuerelektronik, die aus den Signalen aller Einzeldetektoren 131 jene Einzeldetektoren 131 bestimmt, welche dem magnetischen Polrad 120 am nächsten sind. Um eine hohe Messgenauigkeit auch bezüglich der Axialposition zu erreichen, werden die Signale zweier Einzeldetektor-Paare verwendet, die zwei benachbarten Sensor-Zeilen zugeordnet sind. Somit kann auch eine Interpolation zwischen zwei benachbarten Sensor-Zeilen erfolgen.

Die Auswertung der Messsignale der Einzeldetektoren kann auf besonders günstige Art und Weise dadurch erfolgen, dass aus den Signalen des Sensor-Paares, das dem Multipol-Magnetrad am nächsten ist, der Drehwinkel der Saugpipette 110 berechnet wird. Außerdem kann aus den Signalen der Sensoren neben diesem genannten Sensor-Paar die axiale Position der Saugpipette 110 auf besonders günstige Art und Weise berechnet werden.

Hinsichtlich der Dimensionierung der Messvorrichtung 100 hat sich in einer Reihe von experimentellen Untersuchungen herausgestellt, dass eine hohe Messgenauigkeit dann erreichbar ist, wenn die Magnete 125 entlang des Außenumfangs eine Polbreite in der Größenordnung von einigen wenigen Millimetern aufweisen. Hinsichtlich des Abstandes zwischen dem Sensor-Array 130 und dem Außenrand des Multipol-Magnetrades 120 hat sich ein Abstand in der Größenordnung von 0,5 mm als geeignet erwiesen.

Das Sensor-Array 130 besteht gemäß dem hier dargestellten Ausführungsbeispiel aus einem einzigen Sensor-Chip, auf dem Hall-Sensoren oder Magnetowiderstand-Sensoren so angeordnet sind, dass immer mindestens ein Sensor-Paar zur Drehwinkelerfassung verwendet werden kann. Aus dem Signal mindestens eines weiteren Sensors, welcher einer unterschiedlichen Sensor-Zeile zugeordnet ist, kann dann die axiale Position der Saugpipette 110 mit hoher Genauigkeit bestimmt werden. Dabei wird ggf. das Prinzip der Interpolation zwischen zwei Messsignalen verwendet.

Es wird darauf hingewiesen, dass die Genauigkeit der gesamten Messvorrichtung 100 von der Präzision der alternierend angeordneten Permanentmagneten 125 am Außenumfang des Multipol-Magnetrades 120 und von der genauen Position der Einzeldetektoren 131 in dem Sensor-Array 130 abhängt. Hinsichtlich der Genauigkeit bezüglich des zu messenden Drehwinkels ist die Präzision bei der Fertigung des Multipol-Magnetrades 120 maßgeblich, hinsichtlich der Genauigkeit bezüglich der axialen Positionsmessung ist eine genaue Kenntnis der exakten räumlichen Lage der Einzeldetektoren 131 im Sensor-Array 130 maßgeblich. Da bei der Fertigung von Sensor-Arrays im Rahmen von bekannten Halbleiter-Herstellungsverfahren die Genauigkeit hinsichtlich der Position der Einzeldetektoren 131 sehr hoch ist, muss bei der Fertigung der Messvorrichtung 100 in der Praxis nur noch auf die Fertigungs-Genauigkeit des Rings 122 des Multipol-Magnetrades 120 geachtet werden. Somit kann auf vergleichsweise einfache Art und Weise eine Messvorrichtung 100 zur kombinierten Erfassung eines Drehwinkels und einer Linearverschiebung aufgebaut werden, welche Messvorrichtung 100 eine hohe Messgenauigkeit aufweist.

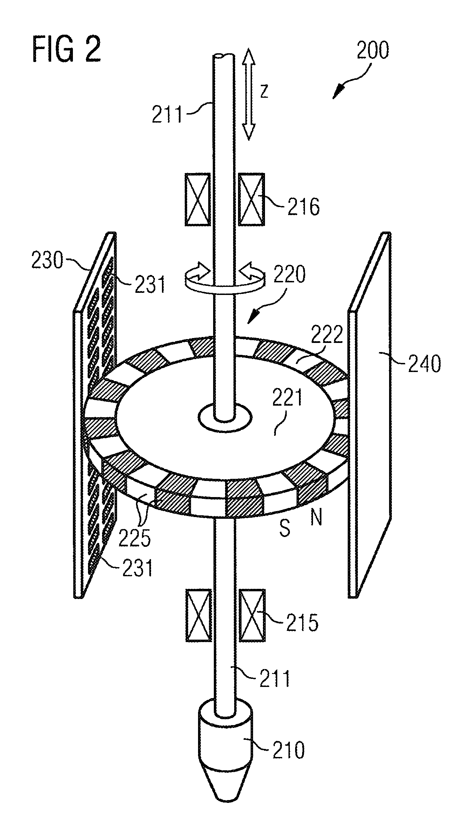

Figur 2 zeigt eine Messvorrichtung 200, welche sich von der Messvorrichtung 100 lediglich dadurch unterscheidet, dass nicht nur ein Sensor-Array, sondern zwei Sensor-Arrays 230 und 240 vorgesehen sind. Die beiden Sensor-Arrays 230 und 240 sind mit einer in Figur 2 nicht dargestellten Auswerteeinheit verbunden, wobei zur Bestimmung sowohl des Drehwinkels als auch der axialen Position die entsprechenden Messsignale von beiden Sensor-Arrays 230 und 240 herangezogen werden können.

Insbesondere die in Figur 2 dargestellte Anordnung, bei der die beiden Sensor-Arrays 230 und 240 einander gegenüberliegend angeordnet sind, hat den Vorteil, dass die Drehwinkelmessung unabhängig ist (a) von einer Exzentrizität der Welle, (b) von einer Exzentrizität des Multipolmagnetrades, (c) von einer ungleichmäßigen Magnetfeldstärke der einzelnen entlang des Außenumfangs des Multipol-Magnetrades 220 angeordneten Magnete und/oder von (d) einem Spiel der Welle in der Führungseinrichtung. Auf diese Weise wird zum einen die Messgenauigkeit der Messvorrichtung 200 erhöht und zum anderen wird der Aufwand für die Lagerung der Welle 211 und für die Montage der Messvorrichtung 200 reduziert.

## Patentansprüche

1. Messvorrichtung zum gleichzeitigen Erfassen eines Drehwinkels und einer Verschiebeposition eines Objektes (110), aufweisend
• einen Drehgeber (120),
- welcher mit dem Objekt (110) ortsfest verbindbar ist und
- welcher mehrere detektierbare Elemente (125) umfasst, die entlang zumindest einer Außenumfangslinie des Drehgebers (120) in äquidistanten Abständen angeordnet sind,
• eine Führungseinrichtung (115, 116), derart ausgebildet, dass der Drehgeber (120) um eine Drehachse (111) drehbar und entlang dieser Drehachse (111) verschiebbar gelagert ist,
• ein Sensor-Array (130), welches
mehrere Einzeldetektoren (131) umfasst, die in einer Ebene parallel zur Drehachse (111) angeordnet sind, welche Ebene einen vorbestimmten Abstand zum Außenrand des Drehgebers (120) aufweist, und
• eine Auswerteeinheit (150),
- welche mit den Einzeldetektoren (131) gekoppelt ist und
- welche derart eingerichtet ist, dass aus dem Signal der Einzeldetektoren (131) sowohl der Drehwinkel als auch die Verschiebeposition des Objektes (110) ermittelbar ist,
wobei die Ermittlung von Verschiebeposition und Drehwinkel dahingehend entkoppelt ist,
- dass bei einem Verschieben des Drehgebers (120) Messsignale von unterschiedlichen Einzeldetektoren (131) erfasst und ausgewertet werden, welche Einzeldetektoren (131) neben unterschiedlichen Längsabschnitten der Drehachse (111) angeordnet sind, und
- dass bei einem Verdrehen des Drehgebers (120) zumindest ein Messsignal eines Einzeldetektors (131) erfasst und ausgewertet wird, der neben einem bestimmten Längsabschnitt der Drehachse (111) angeordnet ist.

2. Messvorrichtung nach Anspruch 1, bei der
die Einzeldetektoren (131) in Sensor-Zeilen und in Sensor-Spalten angeordnet sind, wobei
die Sensor-Zeilen senkrecht zur Drehachse (111) und
die Sensor-Spalten parallel zur Drehachse (111) orientiert sind.

3. Messvorrichtung nach Anspruch 2, bei der die Auswerteeinheit (150) derart eingerichtet ist, dass
der genaue Drehwinkel aus dem Signal von zwei Einzeldetektoren (131) ermittelbar ist, welche unterschiedlichen Sensor-Spalten zugeordnet sind.

4. Messvorrichtung nach einem der Ansprüche 2 bis 3, bei der
• die detektierbaren Elemente (125) entlang des Außenumfangs des Drehgebers (120) in jeweils einem Element-Abstand voneinander angeordnet sind und
• zwei in einer Sensor-Zeile benachbarte Einzeldetektoren (131) in einen Sensor-Abstand voneinander angeordnet sind, wobei
der Sensor-Abstand gerade halb so groß ist wie der Element-Abstand.

5. Messvorrichtung nach einem der Ansprüche 2 bis 4, bei der die Auswerteeinheit (150) einen Zähler aufweist, welcher Signalfolgen von zwei zu unterschiedlichen Sensor-Spalten zugeordneten Einzeldetektoren (131) zählt.

6. Messvorrichtung nach einem der Ansprüche 2 bis 5, bei der die Auswerteeinheit (150) derart eingerichtet ist, dass
die genaue Verschiebeposition aus dem Signal von zumindest zwei Einzeldetektoren (131) ermittelbar ist, welche unterschiedlichen Sensor-Zeilen zugeordnet sind.

7. Messvorrichtung nach einem der Ansprüche 1 bis 6, bei der
• der Drehgeber ein Multipol-Magnetrad (120) ist,
• die detektierbaren Elemente Magnete (125) sind, die derart angeordnet sind, dass sich entlang des Außenrandes des Multipol-Magnetrades (120) abwechselnd ein Nord- und ein Südpol befindet, und
• die Einzeldetektoren Magnetfeld-Sensoren (131) sind.

8. Messvorrichtung nach Anspruch 7, bei der
das Multipol-Magnetrad (120) eine Nabe (121) und einen um die Nabe herum angeordneten Ring (121) umfasst, welcher einen Hartferrit Werkstoff aufweist.

9. Messvorrichtung nach Anspruch 8, bei der
der Ring (122) auf die Nabe (121) aufgeklebt ist.

10. Messvorrichtung nach einem der Ansprüche 7 bis 9, bei der die Magnetfeld-Sensoren (131) Hall-Sensoren und/oder Magnetowiderstand-Sensoren sind.

11. Messvorrichtung nach einem der Ansprüche 1 bis 10, zusätzlich aufweisend:
ein weiteres Sensor-Array (240), welches
mehrere weitere Einzeldetektoren umfasst, die in einer weiteren Ebene parallel zur Drehachse (211) angeordnet sind, welche weitere Ebene einen vorbestimmten Abstand zum Außenrand des Drehgebers (220) aufweist, wobei
die weiteren Einzeldetektoren (231) ebenfalls mit der Auswerteeinheit gekoppelt sind.

12. Messvorrichtung nach Anspruch 11, bei der
das Sensor-Array und das weitere Sensor-Array auf einander gegenüberliegenden Seiten des Drehgebers (220) angeordnet sind.

## Claims

1. Measuring device for simultaneously determining a rotation angle and a displacement position of an object (110), featuring
• a rotary encoder (120),
- which is able to be linked to the object (110) at a fixed position and
- which comprises a number of detectable elements (125) which are arranged at equidistant intervals along at least one outer circumference line of the rotary encoder (120),
• a guide device (115, 116), which is embodied so that the rotary encoder (120) is able to be rotated around an axis of rotation (111) and is supported along this axis of rotation (111) to allow movement,
• a sensor array (130), which
comprises a number of individual detectors (131) which are arranged in a plane parallel to the axis of rotation, with said plane being at a predetermined distance from the outer edge of the rotary encoder (120), and
• an evaluation unit (150),
- which is coupled to the individual detectors (131) and
- which is configured so as to enable both the angle of rotation and also the displacement position of the object (110) to be determined from the signal of the individual detectors (131)
with the determination of displacement position and angle of rotation being decoupled to the extent that,
- for a displacement of the rotary encoder (120) measuring signals are determined and evaluated from different individual detectors (131), with said individual detectors (131) being arranged next to different longitudinal sections of the axis of rotation (111), and
- when the rotary encoder (120) rotates, at least one measuring signal of an individual detector (131) which is arranged next to a specific longitudinal section of the axis of rotation (111) is determined and evaluated.

2. Measuring device according to claim 1, in which
The individual detectors (131) are arranged in sensor rows and in sensor columns, with
the sensor rows being oriented at right angles to the axis of rotation (111) and
the sensor columns being oriented parallel to the axis of rotation (111).

3. Measuring device according to claim 2, in which the evaluation unit (150) is configured so that the precise angle of rotation is determined from the signal of two individual detectors (131) which are assigned to different sensor columns.

4. Measuring device according to one of the claims 2 to 3, in which
• the detectable elements (125) along of the outer circumference of the rotary encoder (120) are arranged at a distance of one element from each other in each case, and
• two individual detectors adjacent to each other in a sensor row (131) are arranged at a distance of one sensor from each other, with
the sensor distance being half as large as the element distance.

5. Measuring device according to one of the claims 2 to 4, in which the evaluation unit (150) has a counter which counts signal sequences of two individual detectors (131) assigned to different sensor columns.

6. Measuring device according to one of the claims 2 to 5, in which the evaluation unit (150) is configured so as to determine the precise displacement position from the signal of at least two individual detectors (131) which are assigned to different sensor rows.

7. Measuring device according to one of the claims 1 to 6, in which
• the rotary encoder is a multi-pole magnet wheel (120),
• the detectable elements are magnets (125) which are arranged so that a north and a south pole are to be found alternately along the outer edge of the multi-pole magnet wheel (120), and
• the individual detectors are magnetic field sensors (131).

8. Measuring device according to claim 7, in which
the multi-pole magnet wheel (120) comprises a hub (121) and a ring arranged around the hub (121) which features a hard-ferrite material.

9. Measuring device according to claim 8, in which the ring (122) is glued onto the hub (121).

10. Measuring device according to one of the claims 7 to 9, in which the magnetic field sensors (131) are Hall sensors and/or magneto-resistance sensors.

11. Measuring device as claimed in one of the claims 1 to 10, additionally featuring:
a further sensor array (240), which
comprises a number of further individual detectors which are arranged in a plane parallel to the axis of rotation (211), with said further plane being at a predetermined distance from the outer ring of the rotary encoder (220), with
the further individual detectors (231) likewise being coupled to the evaluation unit.

12. Measuring device according to claim 11, in which
the sensor array and the further sensor array are arranged on opposite sides of the rotary encoder (220).

## Revendications

1. Dispositif de mesure destiné à la saisie simultanée d'un angle de rotation et d'une position de décalage d'un objet (110), présentant:
• un encodeur (120),
- lequel est raccordable à l'objet (110) de manière stationnaire et
- lequel comprend plusieurs éléments détectables (125) qui sont disposés le long d'au moins une ligne de circonférence extérieure de l'encodeur (120) à intervalles équidistants,
• un dispositif de guidage (115, 116) exécuté de telle manière que l'encodeur (120) est logé de manière rotative autour d'un axe de rotation (111) et de manière coulissante le long de cet axe de rotation (111),
• un panneau de capteurs (130) lequel
comprend plusieurs détecteurs individuels (131) qui sont disposés dans un plan parallèlement à l'axe de rotation (111), lequel plan présente un écart prédéterminé par rapport au bord extérieur de l'encodeur (120), et
• une unité d'évaluation (150)
- laquelle est couplée aux détecteurs individuels (131) et
- laquelle est réglée de telle manière qu'à partir du signal des détecteurs individuels (131), il est possible de déterminer aussi bien l'angle de rotation que la position de décalage de l'objet (110),
la détermination de la position de décalage et de l'angle de rotation étant autonome du fait
- que lors d'un décalage de l'encodeur (120), des signaux de mesure des différents détecteurs individuels (131) sont saisis et évalués, lesquels détecteurs individuels (131) sont disposés à côté de différentes sections longitudinales de l'axe de rotation (111) et
- que, lors d'une rotation de l'encodeur (120), au moins un signal de mesure d'un détecteur individuel (131) est saisi et évalué, qui est disposé à côté d'une section longitudinale déterminée de l'axe de rotation (111).

2. Dispositif de mesure selon la revendication 1, dans lequel les détecteurs individuels (131) sont disposés en lignes de capteurs et en colonnes de capteurs,
les lignes de capteurs étant verticales par rapport à l'axe de rotation (111), et
les colonnes de capteurs étant orientées parallèlement à l'axe de rotation (111).

3. Dispositif de mesure selon la revendication 2, dans lequel l'unité d'évaluation (150) est réglée de telle manière que l'angle de rotation exact peut être déterminé à partir du signal de deux détecteurs individuels (131) affectés à différentes colonnes de capteurs.

4. Dispositif de mesure selon l'une quelconque des revendications 2 à 3, dans lequel
• les éléments détectables (125) sont disposés mutuellement le long de la circonférence extérieure de l'encodeur (120) dans respectivement un intervalle d'élément et
• deux détecteurs individuels (131) voisins dans une ligne de capteurs sont disposés mutuellement dans un intervalle de capteur,
l'intervalle de capteur étant juste moitié moins grand que l'intervalle d'élément.

5. Dispositif de mesure selon l'une quelconque des revendications 2 à 4, dans lequel
l'unité d'évaluation (150) présente un compteur qui compte les séquences de signal de deux détecteurs individuels (131) affectés à différentes colonnes de capteurs.

6. Dispositif de mesure selon l'une quelconque des revendications 2 à 5, dans lequel
l'unité d'évaluation (150) est réglée de telle manière que la position de décalage exacte peut être déterminée à partir du signal d'au moins deux détecteurs individuels (131), lesquels sont affectés à différentes lignes de capteurs.

7. Dispositif de mesure selon l'une quelconque des revendications 1 à 6, dans lequel
• l'encodeur est une roue magnétique multipôle (120),
• les éléments détectables sont des aimants (125) qui sont disposés de telle manière qu'un pôle nord et un pôle sud se trouvent en alternance le long du bord extérieur de la roue magnétique multipôle (120), et
• les détecteurs individuels sont des capteurs de champ magnétique (131).

8. Dispositif de mesure selon la revendication 7, dans lequel la roue magnétique multipôle (120) comprend un moyeu (121) et un anneau (122) disposé autour du moyeu, lequel anneau présente une matière en ferrite dur.

9. Dispositif de mesure selon la revendication 8, dans lequel l'anneau (122) est collé sur le moyeu (121).

10. Dispositif de mesure selon l'une quelconque des revendications 7 à 9, dans lequel
les capteurs de champ magnétique (131) sont des capteurs de Hall et/ou des capteurs magnétorésistifs.

11. Dispositif de mesure selon l'une quelconque des revendications 1 à 10, présentant en outre:
un autre panneau de capteurs (240), lequel
comprend plusieurs autres détecteurs individuels qui sont disposés dans un autre plan parallèlement à l'axe de rotation (211), lequel autre plan présente un écart prédéterminé par rapport au bord extérieur de l'encodeur (220),
les autres détecteurs individuels (231) étant également couplés à l'unité d'évaluation.

12. Dispositif de mesure selon la revendication 11, dans lequel
le panneau de capteurs et l'autre panneau de capteurs sont disposés sur des côtés opposés de l'encodeur (220).
